Europäisches Patentamt

European Patent Office

Office européen des brevets

(19)

(11) Publication number: **0 069 311**
**B1**

(12) **EUROPEAN PATENT SPECIFICATION**

(45) Date of publication of patent specification: **01.10.86**

(51) Int. Cl.⁴: **H 03 H 9/10**

(21) Application number: **82105696.7**

(22) Date of filing: **28.06.82**

(54) Glass encapsulated quartz oscillator.

(30) Priority: **06.07.81 US 280662**

(43) Date of publication of application:
**12.01.83 Bulletin 83/02**

(45) Publication of the grant of the patent:
**01.10.86 Bulletin 86/40**

(84) Designated Contracting States:
**BE CH DE FR GB IT LI NL SE**

(56) References cited:
**GB-A- 706 169**
**GB-A- 834 333**
**GB-A-1 576 152**
**US-A-2 577 576**

**PATENT ABSTRACTS OF JAPAN, vol.2, no.37,**
**March 13, 1978, page 77 E 78**
**PATENT ABSTRACTS OF JAPAN, vol.1, no.92,**
**August 25, 1977, page 2444 E 77**

(73) Proprietor: **GTE Products Corporation**
**100 West 10th Street**
**Wilmington, DE 19801 (US)**

(72) Inventor: **Hoeber, Henri**
**224, Stationstraat**
**B-3110 Rotselaar (BE)**
Inventor: **Van Noppen, Jean**
**80 Park Nieuwenhove**
**B-3300 Tienen (BE)**
Inventor: **Buckinx, Pol**
**68 Onderwijslaan**
**B-3610 Diepenbeek (BE)**

(74) Representative: **Patentanwälte Grünecker, Dr.**
**Kinkeldey, Dr. Stockmair, Dr. Schumann, Jakob,**
**Dr. Bezold, Meister, Hilgers, Dr. Meyer-Plath**
**Maximilianstrasse 58**
**D-8000 München 22 (DE)**

Courier Press, Leamington Spa, England.

## Description

The invention relates to a method for encapsulating a flat quartz crystal. Such crystals, as shown in the US—PS 3 483 402, 3 877 122 and 4 183 126, are often encapsulated in order to protect them from the environment, for example, humidity, in order to prevent a shift of electrical characteristics throughout the operating life of the crystal.

In the prior art, as may be seen, for example, from the GB—A—83 4333, such encapsulation generally consisted of preformed containers which were relatively expensive and did not readily lend themselves to high speed manufacturing processes. A commonly used prior art encapsulating process employed a preformed rectangular glass container, a preformed glass base, two rigid lead-in wires and two preformed metal springs. First, the lead-in wires were embedded in the glass base and the metal springs were then welded to the lead-in wires. Next, the quartz crystal was conductively bonded to the springs so that one electrode (metallized surface) of the crystal was in electrical contact with one of the springs, and the other metallized surface of the crystal was in electrical contact with the other spring. Finally the mounted crystal was inserted into the glass container, the glass base being a reasonably close fit within the open end of the glass container, and the glass base and the end of the glass container were heated to their soldering point, and fused together to seal the container. This process does not readily lend itself to high speed manufacture.

The task of the invention is, therefore, to find an encapsulating method, according to which the manufacturing of encapsulated quartz crystals may be carried out with high speed and low cost.

This task is solved by a method of encapsulating a flat quartz crystal having an electrode on each surface, the encapsulating method comprising the steps of connecting one lead-in wire by means of an electrically conductive bond directly to one electrode of the quartz crystal, connecting a second lead-in wire by means of an electrically conductive bond directly to the other electrode, disposing the lead-in wires in a holder and inserting the quartz crystal into one end of an open-ended glass tube, heating said end of the glass tube to its softening point, pressing the softened end of the glass tube together with the lead-in wires therebetween to form a press seal in which the lead-in wires are embedded and heating and sealing the other end of the glass tube.

According to these features, the invention uses, in the field of encapsulating quartz crystals, the press seal technique, which per se is known in other technical fields. Furthermore, according to the invention, the only parts required are two lead-in wires and a glass tube. The invention does not need preformed metal springs as was the case in the prior art technique to connect the quartz to the lead-in wires because, according to the invention, the lead-in wires are directly and conductively bonded to the quartz crystal. The conductive bond may be made, for example, by electrically conductive bonding materials, for example, silver-filled epoxy. Or it may be by soldering, welding and the like.

According to the invention, the quartz crystal is then inserted into an open-ended glass tube of suitable diameter and length. The extremities of the lead-in wires protrude outside the glass tube and are secured in a suitable external holder to properly position the quartz crystal within the glass tube. The end of the glass tube is then heated to its softening point and pressed together to seal the end by forming a press seal, the lead-in wires being embedded in the press seal. For this purpose, the lead-in wires are of a type readily sealable to glass, for example, dumet wire for sealing to soft glass. Dumet comprises a nickel-iron core within a copper sheath. Upon cooling, the press seal solidifies and rigidly holds the lead-in wires and quartz crystal.

It may be seen that, according to the direct bonding of the lead-in wires to the quartz crystal and by the use of the press seal technique, the invention does not require preformed parts and is suitable for high speed manufacture.

Next, a circumferential section of the glass tube near the other end thereof is heated to its softening point and the end is then drawn apart from the main body of the glass tube to form a necked-down portion in the glass tube. Said end is then cut off or otherwise removed, leaving the necked-down portion which is of smaller diameter than the glass tube and is suitable as an exhaust tubulation to exhaust, tip-off and seal the glass tube with the quartz crystal therewithin. After exhausting (by vacuum) the atmosphere within the glass tube, the exhaust tubulation may be tipped off under vacuum, to maintain a vacuum within the glass tube. Or an inert gas, for example, dry nitrogen, may be introduced into the glass tube prior to tip-off of the exhaust tube. If necessary, a cooling gas, e.g. nitrogen, may be flowed into the glass tube during the sealing steps in order to cool the quartz crystal and prevent it from being heated above the curie point of the quartz material.

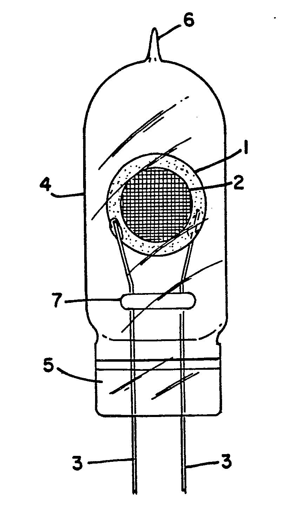

The drawing shows one embodiment of an encapsulated quartz crystal in accordance with this invention.

Quartz crystal 1 comprised a flat circular disk about 8mm in diameter by 0.5mm thick. The metallized portion 2 of each surface was about 6mm in diameter. Lead-in wires 3 were made of dumet, 0.35mm thick, and were fastened to electrodes 2. Glass tube 4 was 11mm outside diameter by 20mm long (internal length). Press seal 5 was about 9mm wide by about 7mm long and was about 2.5mm thick. After exhausting and filling with nitrogen, glass tube 4 was sealed at tip-off 6. If desired, lead-in wires 3 could be embedded in glass bead 7 prior to press sealing in order to bend and hold wires 3 in the correct position for fastening crystal 1 thereto. Also, if necessary, the frequency of quartz crystal 1 can be adjusted prior to the top end sealing by techniques known to the art, for example, by an lodine trimming system. Or crystal 1 can be trimmed to its final frequency by means of a laser after complete sealing of the glass tube.

In some cases, it may be desirable for glass tube 4 to be flattened into, say a flat substantially rectangular shape, instead of being circular, in order to reduce the size of glass tube 4 or in order to accommodate a rectangular quartz crystal 1. In such a case, the open-ended round glass tube would be heated and flattened prior to mounting of the quartz crystal/lead-in wire assembly therein. After embedment of said assembly in a press seal at one end of the flattened glass tube, the other end could also be sealed by a press seal without the need of an exhaust tubulation. In such a case, nitrogen, for example, could be introduced into the interior of the flattened glass tube by means of a small diameter hollow metal needle inserted therein while the glass was heated to its softening point. At the proper time, the needle would be removed and the press seal made immediately, thereby providing the desired nitrogen fill within the glass tube.

## Claims

1. Method of encapsulating a flat quartz crystal (1) having an electrode (2) on each surface the encapsulating method comprising the steps of connecting one lead-in wire (3) by means of an electrically conductive bond directly to one electrode (4) of the quartz crystal, connecting a second lead-in wire (3) by means of an electrically conductive bond directly to the other electrode (2), disposing the lead-in wires (3) in a holder and inserting the quartz crystal (1) into one end of an open-ended glass tube (4), heating said end of the glass tube (4) to its softening point, pressing the softened end of the glass tube (4) together with the lead-in wires (3) therebetween to form a press seal (5) in which the lead-in wires (3) are embedded and heating and sealing the other end of the glass tube (4).

2. The method according to claim 1 wherein the glass tube (4) is circular and the other end is sealed by heating a circumferential section of the glass tube (4) near said other end thereof to its softening point, drawing out the softened section to form a necked down portion, removing enough of said other end of the glass tube to permit the necked down portion to be used as an exhaust tubulation, exhausting the glass tube (4) through the exhaust tubulation and sealing the glass tube (4) by tipping off the exhaust tubulation.

3. The process according to claim 1 or 2, wherein the lead-in wires (3) are embedded in a glass bead prior to press sealing.

4. The process according to any one of the foregoing claims, wherein an inert gas is introduced into the glass tube (4) after the exhausting step.

5. The process according to any one of the foregoing claims, including the step of adjusting the frequency of the quartz crystal prior to the necking step.

6. The method according to claim 1, wherein the open-ended glass tube has a flat substantially rectangular shape and the other end of the glass tube (4) is sealed by a press seal (5).

7. The method according to claim 1, including the step of adjusting the frequency of the quartz crystal (1) after the glass tube (4) is completely sealed.

8. An encapsulated quartz crystal (1) comprising a flat quartz crystal (1) having an electrode (2) on each surface and disposed within a sealed glass tube (4), with a tip-off (6) at one end, characterised in that two lead-in wires (3) are directly bonded to the electrodes (2) of the quartz crystal (1) respectively and, that on the other end of the glass tube a press seal (5) is provided and that the lead-in wires (3) are embedded in and extend through the said press seal (5).

9. The quartz crystal according to claim 8, characterised in, that a glass bead (7) is provided, in which the lead-in wires (3) are embedded, the glass bead (7) being disposed between the quartz crystal (1) and the press seal (5).

## Revendications

1. Procédé d'encapsulation d'un cristal de quartz plat (1) comportant une électrode (2) sur chaque face, le procédé d'encapsulation comprenant les étapes suivantes:
— on relie directement une première entrée de courant (3) par l'intermédiaire d'un conducteur électrique à une électrode (2) du cristal de quartz,
— on relie directement une seconde entrée de courant (3) par l'intermédiaire d'un conducteur électrique à l'autre électrode (2),
— on dispose les entrées de courant (3) sur un support,
— on introduit le cristal de quartz (1) par une extrémité d'un tube de verre ayant une extrémité ouverte (4),
— on chauffe la dite extrémité du tube de verre (4) jusqu'à son point de fusion, et on presse l'extrémité ramollie du tube de verre (4) avec les entrées de courant la traversant, de manière à constituer un pied pressé (5) dans lequel les entrées de courant sont scellées, et
— on chauffe et scelle l'autre extrémité du tube de verre (4).

2. Procédé selon la revendication 1 caractérisé en ce que le tube de verre (4) présente une section circulaire et que l'autre extrémité est scellée en chauffant la section circulaire du tube de verre (4) à proximité de son extrémité jusqu'à son point de fusion, puis en étirant la partie ramollie de manière à former un collet, puis en enlevant suffisamment de la dite autre extrémité du tube de verre pour permettre au collet de servir de queusot, puis en faisant le vide dans le tube de verre (4) au moyen du queusot, et, enfin, en scellant le queusot du tube de verre (4).

3. Procédé selon la revendication 1 ou 2 caractérisé en ce que les entrées de courant (3) sont scellées dans une perle de verre avant l'étape de scellement par pression.

4. Procédé selon l'une quelconque des revendications précédentes caractérisé en ce que l'on introduit un gaz inerte à l'intérieur du tube de verre (4) après avoir fait le vide à l'intérieur.

5. Procédé selon l'une quelconque des revendications précédentes caractérisé en ce qu'il comprend une étape au cours de laquelle on ajuste la fréquence du cristal de quartz avant l'étape de formation du collet.

6. Procédé selon la revendication 1 caractérisé en ce que le tube de verre ayant une extrémité ouverte présente une forme rectangulaire substantiellement plane, et que l'autre extrémité du tube de verre (4) est scellée par pressage.

7. Procédé selon la revendication 1 caractérisé en ce que l'étape d'ajustement de la fréquence du cristal de quartz (1) est effectuée après scellement complet du tube de verre (4).

8. Cristal de quartz encapsulé (1) comprenant un cristal de quartz plat (1) ayant une électrode (2) sur chaque face et disposé à l'intérieur d'un tube de verre scellé (4), pourvu d'un queusot (6) à une extrémité, caractérisé en ce que deux entrées de courant (3) sont directement reliées aux électrodes (2) du cristal de quartz (1) respectivement, et que, à l'autre extrémité du tube de verre, est réalisé un pied pressé, et que les entrées de courant (3) sont scellées dans et font saillie du dit pied pressé (5).

9. Cristal de quartz selon la revendication 8 caractérisé en ce que les entrées de courant (3) sont pourvues d'une perle de verre (7) qui est disposée entre le cristal de quartz (1) et le pied scellé (5).

**Patentansprüche**

1. Verfahren zum Einkapseln eines Flachquartzkristalles (1), der auf jeder Oberfläche eine Elektrode (2) aufweist, wobei das Verfahren folgende Schritte umfaßt

das Verbinden eines Anschlußdrahtes (3) mit Hilfe eines elektrischleitenden Verbindungsmittels unmittelbar an eine Elektrode (4) des Quartzkristalls,

das Verbinden eines zweiten Anschlußdrahtes (3) mit Hilfe eines elektrischleitenden Verbindungsmittels unmittelbar an die andere Elektrode (2),

das Anordnen der Anschlußdrähte (3) in einem Halter und Einschieben des Quartzkristalls (1) in ein Ende einer am Ende offenen Glasröhre (4),

das Heizen des Endes der Glasröhre (4) bis zum Schmelzpunkt,

das Zusammenpressen des geschmolzenen Endes der Glasröhre mit den Anschlußdrähten dazwischen, um so eine

Preßdichtung (5) herzustellen, in der die Anschlußdrähte (3) eingebettet sind und

das Heizen und Abdichten des anderen Endes der Glasröhre (4).

2. Verfahren nach Anspruch 1, wobei die Glasröhre (4) rund ist und wobei das andere Ende durch folgende Schritte abgedichtet wird,

das Aufheizen eines Umfangsabschnitts der Glasröhre (4) nahe dieses anderen Endes bis zum Schmelzpunkt,

das Ausziehen des geschmolzenen Abschnitts zur Bildung eines eingeschnürten Teils,

das Entfernen von Material am anderen Ende der Glasröhre so, daß der eingeschnürte Teil als Absaurohr dienen kann, das Evakuieren der Glasröhre (4) durch das Absaugrohr und das Abdichten der Glasröhre (4) durch Entfernen des Absaugrohres.

3. Verfahren nach Anspruch 1 oder 2, wobei die Anschlußdrähte (3) vor dem Abdichten durch Verpressen in einen Glaswulst eingebettet werden.

4. Verfahren nach irgendeinem der vorangegangenen Ansprüche, wobei ein Edelgas nach dem Evakuierungsschritt in die Glasröhre (4) gefüllt wird.

5. Verfahren nach irgendeinem der vorangegangenen Ansprüche, welches einen Verfahrensschritt einschließt, bei dem die Frequenz des Quartzkristalls vor dem Einschnürvorgang justiert wird.

6. Verfahren nach Anspruch 1, wobei die an den Seiten offene Glasröhre eine im wesentlichen flache rechteckige Form hat und wobei das andere Ende der Glasröhre (4) mit einer Preßdichtung (5) abgedichtet wird.

7. Verfahren nach Anspruch 1, wobei die Frequenz des Quartzkristalls (1) justiert wird, nachdem die Glasröhre (4) vollständig abgedichtet worden ist.

8. Umhüllter Quartzkristall (1) mit einem flachen Quartzkristall (1), der eine Elektrode (2) auf jeder seiner Oberflächen aufweist und der in einer abgedichteten Glasröhre (4) angeordnet ist, mit einer Spitze (6) an einem Ende,

dadurch gekennzeichnet, daß zwei Anschlußdrähte unmittelbar jeweils mit den am anderen Ende der Glasröhre eine Preßdichtung (5) vorgesehen ist und daß die Anschlußdrähte (3) in diese Preßdichtung (5) eingebettet sind und sich dort hindurcherstrecken.

9. Quartzkristall nach Anspruch 8, dadurch gekennzeichnet, daß ein Glaswulst (7) vorgesehen ist, in den die Anschlußdrähte (3) eingebettet sind und daß der Glaswulst (7) zwischen dem Quartzkristall (1) und der Preßdichtung (5) angeordnet ist.

0 069 311